**Europäisches Patentamt**

**European Patent Office**

**Office européen des brevets**

(19)

(11) **EP 1 229 337 A1**

(12) **EUROPÄISCHE PATENTANMELDUNG**

(43) Veröffentlichungstag:
07.08.2002 Patentblatt 2002/32

(51) Int Cl.$^7$: **G01R 15/24**

(21) Anmeldenummer: 01810120.4

(22) Anmeldetag: 06.02.2001

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(71) Anmelder: **ABB RESEARCH LTD.**
**8050 Zürich (CH)**

(72) Erfinder:
• **Stanimirov, Michael**
**5400 Baden (CH)**
• **Bohnert, Klaus**
**5452 Oberrohrdorf (CH)**

(74) Vertreter: **ABB Patent Attorneys**
**c/o ABB Schweiz AG**
**Brown Boveri Strasse 6**
**5400 Baden (CH)**

(54) **Verfahren zur temparaturkompensierten elektro-optischen Messung einer elektrischen Spannung**

(57)    Zur Messung einer elektrischen Spannung in einem elektro-optischen Spannungswandler wird polarisiertes Licht zweier Wellenlängen durch das Medium (1) geschickt. Ausgangsseitig wird das Licht durch einen Polarisator (10) geführt und das verbleibende Signal wird gemessen. Um die Temperaturabhängigkeit der elektro-optischen Koeffizienten zu kompensieren, werden die Messresultate beider Wellenlänge miteinander verglichen und es wird derjenige Spannungswert verwendet, der mit beiden Messungen konsistent ist.

Fig. 1

Printed by Jouve, 75001 PARIS (FR)

**Beschreibung**

Technisches Gebiet

Die Erfindung betrifft ein Verfahren zur Messung einer elektrischen Spannung mit einem elektro-optischen Medium gemäss Oberbegriff von Anspruch 1.

Stand der Technik

Ein elektro-optisches Medium ist ein Material, dessen Brechungsindex bzw. dessen Lichtausbreitungsgeschwindigkeit sich für mindestens eine Lichtpolarisation ändert, wenn ein elektrisches Feld angelegt wird.
Die Messung elektrischer Spannungen mittels elektro-optischer Medien ist bekannt. Ein entsprechendes Gerät wird z.B. in US 4 904 931 offenbart. Es enthält einen elektro-optischen Kristall zwischen zwei Polarisatoren. Durch den Pockels-Effekt wird im Kristall eine Änderung der Brechungsindizes erzeugt, die zu einer Modulation der Lichtintensität nach dem zweiten Polarisator führt. Diese Modulation ist periodisch von der Spannung abhängig. Um ein eindeutiges Messresultat zu erhalten, werden in US 4 904 931 deshalb zwei Strahlen gleicher Wellenlänge durch den Kristall geführt.
US 4 531 092 beschreibt ein Verfahren zur Messung einer elektrischen Spannung, bei welchem zwei Strahlen unterschiedlicher Wellenlänge durch einen elektro-optischen Kristall geschickt werden. Dabei wird nur einer der beiden Strahlen ausgangsseitig polarisiert, so dass die Intensität des zweiten Strahls nicht von der Spannung abhängig ist. Diese Massnahme erlaubt es, den zweiten Strahl als Referenzgrösse zu verwenden und die Genauigkeit der Messung zu verbessern.
Bei Verfahren der oben erwähnten Art muss der effektive elektro-optische Koeffizient genau bekannt sein. Da dieser Koeffizient in der Regel temperaturabhängig ist, kann es zu Ungenauigkeiten kommen.

Darstellung der Erfindung

Es stellt sich die Aufgabe, ein Verfahren der eingangs genannten Art bereitzustellen, das in einfacher Weise temperaturabhängige Schwankungen zu kompensieren vermag.
Diese Aufgabe wird vom Verfahren gemäss Anspruch 1 gelöst.
Erfindungsgemäss wird das elektro-optische Medium also von zwei Lichtstrahlen unterschiedlicher Wellenlänge durchsetzt, wobei die Signale $A_1$, $A_2$ beider Lichtstrahlen nach dem Ausgangspolarisator gemessen werden. Diese Signale $A_1$, $A_2$ sind Funktionen $f_1$, $f_2$ der zu messenden elektrischen Spannung $V$ und der Temperatur $T$. Erfindungsgemäss werden diejenigen Werte der Temperatur $T$ und der Spannung $V$ gesucht werden, die das Gleichungssystem

$$A_1 = f_1(T, V)$$

und

$$A_2 = f_2(T, V)$$

lösen. Somit wird die zusätzliche Information, die aus der Messung bei einer zweiten Wellenlänge resultiert, für die Elimination der Temperaturabhängigkeit verwendet.

Kurze Beschreibung der Zeichnung

Weitere Ausgestaltungen, Vorteile und Anwendungen der Erfindung ergeben sich aus den abhängigen Ansprüchen und aus der nun folgenden Beschreibung anhand der Figur. Dabei zeigt:

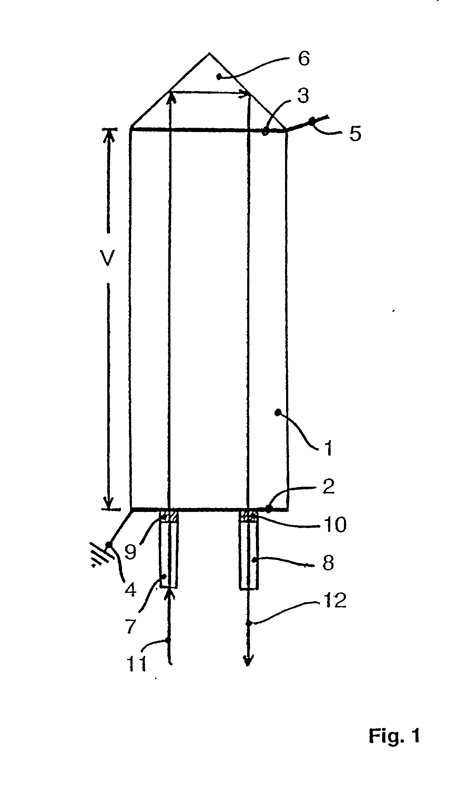

Fig. 1 eine schematische Darstellung eines zur Durchführung der Erfindung geeigneten Spannungswandlers.

Wege zur Ausführung der Erfindung

In Fig. 1 ist eine schematische Darstellung eines quaderförmigen BGO-Kristalls 1 zu erkennen, der an seinen beiden Stirnseiten mit einer Beschichtung aus einem elektrisch leitfähigen, lichtdurchlässigen Material zur Bildung von zwei Elektroden 2, 3 versehen ist. Die eine Elektrode 2 dient als Erdpotential-Anschluss 4 und die andere Elektrode 3 ist als Hochspannungspotential-Anschluss 5 vorgesehen. Die zwischen den Elektroden 2, 3 angelegte Spannung ist mit $V$ bezeichnet. Auf der die Elektrode 3 bildenden Stirnseite des BGO-Kristalls 1 ist ein Umlenkprisma 6 angeordnet, während sich an der die Elektrode 2 bildenden Stirnseite des BGO-Kristalls 1 zwei lineare Polarisatoren (bzw. Analysatoren) 9 bzw. 10 befinden, an welche sich Kollimatoren 7 bzw. 8 anschliessen.

Die Polarisatoren 9, 10 sind unter 45° zu den Achsen des Kristalls orientiert. Sie können zueinander parallel oder um 90° gekreuzt sein.

In den Kollimator 7 werden zwei Lichtstrahlen 11 unterschiedlicher Wellenlänge eingekoppelt. Sie durchläufen den Polarisator 9. Sie treten polarisiert durch die Elektrode 2, in den BGO-Kristall 1 und durch die Elektrode 3, werden an den Grenzflächen des Umlenkprismas 6 reflektiert und durchläufen anschliessend die Elektrode 3, den BGO-Kristall 1, die Elektrode 2, den Polarisator 10 und den Kollimator 8. Die ausgekoppelten Lichtstrahlen sind mit Ziffer 12 bezeichnet. Sie werden in einem nicht dargestellten Strahlteiler separiert und ihre Signale werden einzeln erfasst.

Sind die Polarisatoren parallel, so gilt bei Lichtausbreitung entlang der optischen Achse z für die Signalstärke $A_i$ jedes Lichtstrahls $i$ = 1,2 nach dem Polarisator 10

$$A_i \;=\; A_{0,i} \,\cdot\, \cos^2\!\left(\frac{\pi}{2} \,\cdot\, \frac{V}{V_h}\right), \qquad\qquad (1)$$

wobei $A_{0,i}$ die Signalamplitude des Lichtstrahls $i$ und $V_h$ die Halbwellenspannung für die vorliegende Konfiguration ist. Im vorliegenden Fall wird das elektrische Feld in z-Richtung des Kristalls angelegt und es gilt für die Halbwellenspannung $V_h$

$$V_h = \frac{\lambda}{2 \,\cdot\, r_{63} \,\cdot\, n^3}, \qquad\qquad (2)$$

wobei $r_{63}$ der bei der vorliegenden Konfiguration effektive elektro-optische Koeffizient des Materials, $\lambda$ die Lichtwellenlänge des jeweiligen Lichtstrahls und n der Brechungsindex des Kristalls in x- bzw. y-Richtung ist.

Sind die Polarisatoren um 90° zueinander verdreht, so gilt anstelle von Gleichung (1)

$$A_i \;=\; A_{0,i} \,\cdot\, \sin^2\!\left(\frac{\pi}{2} \,\cdot\, \frac{V}{V_h}\right), \qquad\qquad (1')$$

In einer bevorzugten Ausführung wird zusätzlich zwischen dem Kristall und dem Ausgangspolarisator (oder zwischen dem Eingangspolarisator und dem Kristall) eine Phasenverzögerungsplatte mit einer Verzögerung und Orientierung derart eingefügt, dass ohne angelegte Spannung der Phasenunterschied der beiden orthogonalen Polarisationen am Ausgangspolarisator 90° beträgt. Die Signalstärke $A_i$ ist in diesem Fall gegeben durch

$$A_i \;=\; A_{0,i} \,\cdot\, \sin^2\!\left(\frac{\pi}{2} \,\cdot\, \frac{V}{V_h} \,-\, \frac{\pi}{4}\right), \qquad\qquad (1^*)$$

Damit die Phasenverzögerungsplatte bei beiden Wellenlängen eine Verzögerung von 90° erzeugt, ist eine Platte höherer Ordnung zu verwenden. Der Vorteil der Verwendung einer zusätzlichen Phasenverzögerungsplatte liegt darin, dass zwischen positiven und negativen Spannungen unterschieden werden kann.

In vielen gängigen elektro-optischen Medien hängen die elektro-optischen Koeffizienten $r$ relativ stark von der Temperatur $T$ ab, d.h. es existiert eine im Allgemeinen bekannte Temperaturabhängigkeit

$$r = r(\mathrm{T}). \qquad\qquad (3)$$

Dabei steht der Wert r für den bei der jeweiligen Konfiguration, Kristallsymmetrie und Wellenlänge wirksamen effektiven elektro-optischen Koeffizienten. Im obigen Beispiel ist $r = r_{63}$.

Die Gleichungen (1), (1') bzw. (1*) lassen sich, unter Berücksichtigung der Temperaturabhängigkeit, für zwei Lichtstrahlen verallgemeinert wie folgt schreiben:

$$A_1 = f_1(V, T) \qquad (4a)$$

und

$$A_2 = f_2(V, T), \qquad (4b)$$

wobei z.B. im Falle gekreuzter Polarisatoren 9, 10 die Funktionen $f_i$ gegeben sind durch

$$f_i(V, T) = A_{0,i} \cdot \sin^2\left(\frac{\pi}{2} \cdot \frac{V}{V_h(\lambda_i, T)}\right). \qquad (5)$$

Für den Fall paralleler Polarisatoren ist der Sinus durch den Kosinus zu ersetzen.

In linearer Näherung gilt für die Temperaturabhängigkeit von r z.B.

$$r(T) = r(T_0) + K \cdot \Delta T, \qquad (6)$$

wobei $r(T_0)$ der als bekannt vorausgesetzte elektro-optische Koeffizient bei einer Referenztemperatur $T_0$, $K$ ein bekannter Temperaturkoeffizient und $\Delta T = T - T_0$ ist. Der genaue Temperaturwert $T$ des elektro-optischen Mediums ist in der Regel nicht bekannt.

Für das obige Beispiel wird Gleichungssystem (4) im Fall gemäss Gleichung (1') zu

$$A_1(V, T) = \frac{A_{0,1}}{2} \cdot \left[1 - \cos\left(2\pi \cdot \frac{n^3 \cdot (r_{63}(T_0) + K \cdot \Delta T)}{\lambda_1} \cdot V\right)\right]$$

$$A_2(V, T) = \frac{A_{0,2}}{2} \cdot \left[1 - \cos\left(2\pi \cdot \frac{n^3 \cdot (r_{63}(T_0) + K \cdot \Delta T)}{\lambda_2} \cdot V\right)\right] \qquad (7)$$

Der unbekannte Parameter $\Delta T$ und somit die Temperatur $T$ bzw. der elektro-optische Koeffizient $r_{63}(T)$ kann aus Gleichungssystem (7) berechnet werden. Es gilt:

$$\Delta T = \frac{af - ce}{de - bf} \quad mit$$

$$a = 2\pi \cdot n^3 \cdot r_{63}(T_0) / \lambda_1$$

$$b = 2\pi \cdot n^3 \cdot K / \lambda_1$$

$$c = 2\pi \cdot n^3 \cdot r_{63}(T_0) / \lambda_2 \qquad\qquad (8)$$

$$d = 2\pi \cdot n^3 \cdot K / \lambda_2$$

$$e = \arccos\left(1 - \frac{2A_1}{A_{0,1}}\right)$$

$$f = \arccos\left(1 - \frac{2A_2}{A_{0,2}}\right)$$

Ist $\Delta T$ einmal bekannt, so kann die Spannung $V$ aus einer der Gleichungen (7) direkt berechnet werden. Es gilt

$$V = \arccos\left(1 - \frac{2 \cdot A_i}{A_{0,i}}\right) \cdot \frac{\lambda_i}{2\pi \cdot n^3\left(r_{63}(T_0) + K \cdot \Delta T\right)} \cdot \qquad (9)$$

Für $V \leq V_h$ hat Gleichung (9) eine eindeutige Lösung. Für $V > V_h$ ist diejenige Lösung zu suchen, die beide Gleichungen (4) (bzw. (9) für $i$ = 1 und 2) löst.

Grundsätzlich kann die Temperaturkorrektur des elektro-optischen Koeffizienten gemäss Gleichung (8) und (6) mit wesentlich geringerer Rate erfolgen als die eigentliche Messung der Spannung $V$. Es ist auch möglich, die Temperatur nur zu bestimmen, wenn die jeweilige Spannung unterhalb der Halbwellenspannung liegt, so dass das Problem der nicht-eindeutigen Spannungsbestimmung keine Rolle spielt.

Die Temperaturkorrektur erfolgt gemäss Gleichung (5) bzw. (6) mit der nach (8) ermittelten Temperaturabweichung $\Delta T$. Dank dieser Massnahme sind die elektro-optischen Koeffizienten genauer bekannt, so dass der Spannungswert $V$ mit grösserer Genauigkeit und Zuverlässigkeit ermittelt werden kann.

Es ist ebenfalls möglich, das in (8) beschriebene Kompensationsverfahren auf den Fall paralleler Polarisatoren gemäss Gleichung (1) zu übertragen, wobei sich das Gleichungssystem (7) und die Formeln für $e$ und $f$ in Gleichung (8) entsprechend ändern.

Das Kompensationsverfahren lässt sich auch auf Fälle verallgemeinern, bei welchen die Temperaturabhängigkeit des elektro-optischen Koeffizienten nicht linear ist, was insbesondere in der Nähe eines Phasenübergangs eines elektro-optischen Mediums der Fall sein kann. In diesem Fall ist in Gleichungssystem (7) die entsprechende Funktion $r(T)$ einzusetzen. Nötigenfalls muss die Lösung von Gleichungssystem (7) sodann numerisch bestimmt werden.

In den obigen Beispielen wird als elektro-optisches Medium ein BGO-Kristall verwendet, wobei das Feld in z-Richtung angelegt wird und das Licht sich in z-Richtung ausbreitet. Es ist auch möglich, andere Geometrien und andere elektro-optische Medien zu verwenden, wie z.B. Kristalle aus $LiNbO_3$ oder BSO oder nichtzentrisch polarisierte Polymere.

Die hier beschriebenen Techniken sind ferner auch auf Medien anwendbar, bei denen der elektro-optische Effekt nicht linear (Pockels-Effekt) sondern quadratisch (Kerr-Effekt) auftritt, wobei insbesondere die Gleichungen (4), (5) und (8) entsprechend anzupassen sind. So ist z.B. in Gleichung (1') der Sinus von einem Quadrat der angelegten Spannung zu berechnen.

Bezugszeichenliste

| | |
|---|---|
| 1: | BGO-Kristall |
| 2, | 3: Elektroden |

| | |
|---|---|
| 4: | Erdpotential-Anschluss |
| 5: | Hochspannungspotential-Anschluss |
| 6: | Umlenkprisma |
| 7, 8: | Kollimatoren |
| 9, 10: | Polarisatoren |
| 11, 12: | eingekoppelter und ausgekoppelter Lichtstrahl |
| $A_{0,i}$: | Signalamplituden |
| $a$, $b$, $c$, $d$, $e$, $f$: | Koeffizienten |
| $K$: | Temperaturkoeffizient |
| $n$: | Brechungsindex |
| $r$: | elektro-optischer Koeffizient |
| $T$: | Temperatur |
| $\Delta T$: | Temperaturabweichung |
| $V$: | Spannung |
| $V_h$: | Halbwellenspannung |
| $\lambda_1$, $\lambda_2$: | Wellenlängen der eingekoppelten Strahlen |

**Patentansprüche**

1. Verfahren zur Messung einer elektrischen Spannung mit einem elektro-optischen Medium (1), wobei das Medium einem von der Spannung abhängigen elektrischen Feld ausgesetzt wird und mindestens zwei polarisierte Licht-strahlen (11) unterschiedlicher Wellenlänge ($\lambda_1$, $\lambda_2$) in das Medium (1) eingestrahlt und nach dem Medium (1) polarisiert werden, und wobei Ausgangssignale $A_1$ und $A_2$ der Lichtstrahlen gemessen werden, wobei $A_1$ und $A_2$ temperaturabhängige Funktionen $f_1$ und $f_2$ der Spannung sind, **dadurch gekennzeichnet, dass** diejenigen Werte der Temperatur $T$ und der Spannung $V$ gesucht werden, die das Gleichungssystem

$$A_1 = f_1(T, V)$$

und

$$A_2 = f_2(T, V)$$

lösen.

2. Verfahren nach einem der vorangehenden Ansprüche, **dadurch gekennzeichnet, dass** eine spannungsinduzierte Brechungsindex-Änderung im Medium (1) über den Pockels-Effekt vom elektrischen Feld abhängt.

3. Verfahren nach Anspruch 2, **dadurch gekennzeichnet, dass** die Spannungsabhängigkeit der Brechungsindex-Änderung durch einen effektiven elektro-optischen Koeffizienten $r$ beschrieben wird, wobei für den effektiven elektro-optischen Koeffizienten $r$ eine bekannte Temperaturabhängigkeit $r = r(T)$ vorausgesetzt wird.

4. Verfahren nach Anspruch 3, **dadurch gekennzeichnet, dass** für den effektiven elektro-optischen Koeffizienten eine lineare Temperaturabhängigkeit

$$r(T) = r(T_0) + K \cdot \Delta T$$

mit

$$\Delta T = T - T_0$$

mit bekannter Grösse $r(T_0)$ bei einer Referenztemperatur $T_0$ und mit bekannter Proportionalitätskonstante $K$ vorausgesezt wird.

5. Verfahren nach einem der vorangehenden Ansprüche, **dadurch gekennzeichnet, dass** die Funktionen $f_1$ und $f_2$ in nicht-eindeutiger Weise von der Spannung $V$ abhängen und dass diejenige Spannung ermittelt wird, für welche beide Gleichungen des Gleichungssystems erfüllt sind.

6. Verfahren nach einem der vorangehenden Ansprüche, **dadurch gekennzeichnet, dass** das Medium ein Kristall, insbesondere ein BGO-Kristall ist.

**Fig. 1**

# EP 1 229 337 A1

Europäisches
Patentamt

**EUROPÄISCHER RECHERCHENBERICHT**

Nummer der Anmeldung

EP 01 81 0120

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | US 5 895 912 A (BOSSELMANN ET AL.) 20. April 1999 (1999-04-20) * Spalte 3, Zeile 44 – Spalte 4, Zeile 8 * * Spalte 10, Zeile 11 – Spalte 11, Zeile 13; Abbildung 4 * ___ | 1,2,5,6 | G01R15/24 |
| A | US 4 629 323 A (MATSUMOTO) 16. Dezember 1986 (1986-12-16) * Spalte 4, Zeile 5 – Zeile 43; Abbildung 2 * ___ | 1,2 | |
| A | EP 0 729 033 A (HITACHI) 28. August 1996 (1996-08-28) * Zusammenfassung * * Seite 6, Zeile 9 – Zeile 18 * ___ | 1 | |

**RECHERCHIERTE SACHGEBIETE (Int.Cl.7)**

G01R

Der vorliegende Recherchenbericht wurde für alle Patentansprüche erstellt

| Recherchenort | Abschlußdatum der Recherche | Prüfer |
|---|---|---|
| DEN HAAG | 3. Juli 2001 | Iwansson, K |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

ANHANG ZUM EUROPÄISCHEN RECHERCHENBERICHT
ÜBER DIE EUROPÄISCHE PATENTANMELDUNG NR.

EP 01 81 0120

In diesem Anhang sind die Mitglieder der Patentfamilien der im obengenannten europäischen Recherchenbericht angeführten
Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

03-07-2001

| Im Recherchenbericht angeführtes Patentdokument | Datum der Veröffentlichung | Mitglied(er) der Patentfamilie | Datum der Veröffentlichung |
|---|---|---|---|
| US 5895912 A | 20-04-1999 | DE 4436181 A | 11-04-1996 |
| | | AT 173832 T | 15-12-1998 |
| | | CA 2202133 A | 18-04-1996 |
| | | CN 1159856 A | 17-09-1997 |
| | | WO 9611409 A | 18-04-1996 |
| | | DE 59504359 D | 07-01-1999 |
| | | EP 0786091 A | 30-07-1997 |
| US 4629323 A | 16-12-1986 | JP 1023067 B | 28-04-1989 |
| | | JP 1540347 C | 31-01-1990 |
| | | JP 59018923 A | 31-01-1984 |
| | | DE 3326555 A | 02-02-1984 |
| | | GB 2125543 A,B | 07-03-1984 |
| EP 729033 A | 28-08-1996 | JP 8226939 A | 03-09-1996 |

EPO FORM P0461

Für nähere Einzelheiten zu diesem Anhang : siehe Amtsblatt des Europäischen Patentamts, Nr. 12/82